# EUROPEAN PATENT APPLICATION

(11) **EP 4 501 498 A1**
(43) Date of publication of application: **05.02.2025**
(21) Application number: 23779862.4
(22) Date of filing: 20.03.2023
(51) Int. Cl.: B22F 9/24, H01B 1/22, B22F 1/00, B22F 1/102

(54) **SILVER MICROPARTICLE COMPOSITION**

(30) Priority: 30.03.2022 JP 2022054774
(71) Applicant: Bando Chemical Industries, Ltd., Kobe-shi, Hyogo 650-0047 (JP)
(72) Inventor: MATSUI, Miki, Kobe-shi, Hyogo 650-0047 (JP); NAKAJIMA, Naoya, Kobe-shi, Hyogo 650-0047 (JP)
(74) Representative: Meissner Bolte Partnerschaft mbB
(86) International application number: PCT/JP2023/010983
(87) International publication number: WO 2023/189846

(57) **Abstract**

A silver fine particle composition contains: silver fine particles; an amine; and a diol. The silver fine particles have an average particle diameter of 40 nm or more and 100 nm or less. A volume proportion of silver fine particles having particle diameters of 100 nm or less in an entirety of the silver fine particles is 5 % or higher and 25 % or lower. A volume proportion of silver fine particles having particle diameters of more than 500 nm in the entirety of the silver fine particles is 10 % or higher and 60 % or lower.

## Description

### TECHNICAL FIELD

The present invention relates to a silver fine particle composition.

This application claims priority on Japanese Patent Application No. 2022-054774 filed on March 30, 2022, the entire content of which is incorporated herein by reference.

### BACKGROUND ART

Bonding compositions and electrically conductive inks in which the low-temperature sinterability of silver fine particles is utilized have been attracting attention. After bonding, silver fine particles have physical properties substantially equivalent to physical properties of a typical bulk of silver, and thus have a very high heat resistance and also have favorable reliability and heat dissipation properties.

It has been proposed to use, by utilizing these characteristics, a composition containing such silver fine particles as: a bonding material for bonding a light-emitting element such as an LED to a substrate; a bonding material for bonding a semiconductor chip to a substrate; a bonding material for further bonding each of these substrates to a heat dissipating member; or the like.

In PATENT LITERATURE 1, an inorganic-material bonding material is proposed as an inorganic-material bonding material for bonding an inorganic material such as a metal. The proposed inorganic-material bonding material is an inorganic-material bonding material formed from a paste containing metal colloidal particles and a solvent. The metal colloidal particles are composed of metal nanoparticles (A) and a dispersant (B). The metal nanoparticles (A) have a number-average particle diameter of 50 nm or less and include metal nanoparticles having particle diameters of 100 to 200 nm.

In PATENT LITERATURE 2, a silver fine particle composition is proposed as a bonding composition for bonding an electronic part at a low temperature. The proposed silver fine particle composition contains: silver fine particles; a dispersant containing an alkoxyamine; and a dispersion medium. The content of the dispersant with respect to the content of the silver fine particles is 0.1 to 7.0 mass%. The silver fine particle composition exhibits a weight loss of 70 mass% or higher with respect to all of contained organic components when being heated from room temperature to 200 °C.

### CITATION LIST

### PATENT LITERATURE

| | |
|---|---|
| PATENT LITERATURE 1: | Japanese Laid-Open Patent Publication JP 2011- 94 223 A |
| PATENT LITERATURE 2: | WO 2016/166948 A1 |

### SUMMARY OF THE INVENTION

### TECHNICAL PROBLEM

It is considered that, in a case where silver fine particles are fused at a low temperature (sintered at a low temperature), smaller particle diameters of the silver fine particles enable the silver fine particles to be sintered at a lower temperature.

Meanwhile, when silver fine particles having small particle diameters are sintered, the volume of the resultant silver sintered body significantly decreases from the volume of the silver fine particle composition having been applied. Consequently, many voids are present in the sintered layer having been formed, and it is difficult to obtain a dense sintered layer.

In addition, in a case where a silver fine particle composition as a bonding composition is held between to-be-bonded members and used, if the silver fine particle composition being used is a silver fine particle composition the volume of which significantly decreases after being sintered, it is difficult to firmly bond bonding surfaces having large areas (e.g., 25 mm² or more) to each other.

Thus, in order to suppress such post-sintering decrease in the volume, the particle diameters of the silver fine particles need to be increased. However, increase in the amount of silver fine particles having large particle diameters makes it difficult to sinter the silver fine particles at a low temperature. Consequently, to-be-bonded members that can be bonded are limited, or a higher thermal energy is required for the bonding.

The present invention has been made in view of the above circumstances, and an object of the present invention is to provide a silver fine particle composition that maintains low-temperature sinterability and that can be formed into a sintered layer having few voids and having excellent bonding strength.

### SOLUTION TO THE PROBLEM

(1) A silver fine particle composition of the present invention is
   a silver fine particle composition containing: silver fine particles; an amine; and a diol, wherein
   the silver fine particles have an average particle diameter of 40 nm or more and 100 nm or less,
   a volume proportion of silver fine particles having particle diameters of 100 nm or less in an entirety of the silver fine particles is 5 % or higher and 25 % or lower, and
   a volume proportion of silver fine particles having particle diameters of more than 500 nm in the entirety of the silver fine particles is 10 % or higher and 60 % or lower.
(2) In the silver fine particle composition of the above (1), a volume proportion of silver fine particles having particle diameters of more than 300 nm in the entirety of the silver fine particles is preferably 40 % or higher and 90 % or lower.
(3) In the silver fine particle composition of the above (1) and (2), the amine is preferably one or more types of amines selected from the group consisting of 3-methoxypropylamine, 3-ethoxypropylamine, 3-propoxypropylamine, 3-butoxypropylamine, 2-ethoxypropylamine, 3-isopropoxypropylamine, 2-methoxy-2-methylpropylamine, hexylamine, heptylamine, octylamine, and 2-(2-aminoethoxy)ethanol.
(4) In the silver fine particle composition of the above (1) to (3), the diol is preferably one or more types of diols selected from the group consisting of 1,2-octanediol, 2-methyl-2,4-pentanediol, 2-ethyl-1,3-hexanediol, 2,4-diethyl-1,5-pentanediol, and 3-methyl-1,3-butanediol.
(5) In the silver fine particle composition of the above (1) to (4), the silver fine particles preferably have a content of 85 wt% or higher and 97 wt% or lower.
(6) In the silver fine particle composition of the above (1) to (5), the silver fine particle composition preferably has a shear viscosity of 100 Pa s or higher, the shear viscosity being measured at a shear rate of 5 s⁻¹.

### ADVANTAGEOUS EFFECTS OF THE INVENTION

This silver fine particle composition can be fired at a low temperature, and furthermore, can be formed into a dense sintered silver layer. Consequently, members having large bonding areas can also be firmly bonded to each other.

### BRIEF DESCRIPTION OF DRAWINGS

FIG. 1 is a micrograph of a silver fine particle composition in Example 1.
FIG. 2 is a graph showing a particle diameter distribution of the silver fine particle composition in Example 1.
FIG. 3 is a micrograph of a silver fine particle composition in Example 2.
FIG. 4 is a graph showing a particle diameter distribution of the silver fine particle composition in Example 2.
FIG. 5 is a micrograph of a silver fine particle composition in Example 3.
FIG. 6 is a graph showing a particle diameter distribution of the silver fine particle composition in Example 3.
FIG. 7 is a micrograph of a silver fine particle composition in Example 4.
FIG. 8 is a graph showing a particle diameter distribution of the silver fine particle composition in Example 4.
FIG. 9 is a micrograph of a silver fine particle composition in Example 6.
FIG. 10 is a graph showing a particle diameter distribution of the silver fine particle composition in Example 6.
FIG. 11 is a micrograph of a silver fine particle composition in Example 7.
FIG. 12 is a graph showing a particle diameter distribution of the silver fine particle composition in Example 7.
FIG. 13 is a micrograph of a silver fine particle composition in Comparative Example 1.
FIG. 14 is a graph showing a particle diameter distribution of the silver fine particle composition in Comparative Example 1.
FIG. 15 is a micrograph of a silver fine particle composition in Comparative Example 2.
FIG. 16 is a graph showing a particle diameter distribution of the silver fine particle composition in Comparative Example 2.
FIG. 17 is a micrograph of a silver fine particle composition in Comparative Example 3.
FIG. 18 is a graph showing a particle diameter distribution of the silver fine particle composition in Comparative Example 3.
FIG. 19 is a micrograph of a silver fine particle composition in Comparative Example 4.
FIG. 20 is a graph showing a particle diameter distribution of the silver fine particle composition in Comparative Example 4.
FIG. 21 is a micrograph of a silver fine particle composition in Comparative Example 5.
FIG. 22 is a graph showing a particle diameter distribution of the silver fine particle composition in Comparative Example 5.
FIG. 23 is a micrograph of a silver fine particle composition in Comparative Example 6.
FIG. 24 is a graph showing a particle diameter distribution of the silver fine particle composition in Comparative Example 6.
FIG. 25 is a micrograph of a sintered silver layer formed by using the silver fine particle composition in Example 1.
FIG. 26 is a micrograph of a sintered silver layer formed by using the silver fine particle composition in Comparative Example 2.
FIG. 27 is a micrograph of a sintered silver layer formed by using the silver fine particle composition in Comparative Example 4.

### DETAILED DESCRIPTION

Hereinafter, an embodiment of the present invention will be described.

A silver fine particle composition according to the embodiment of the present invention contains: silver fine particles having specific particle diameters; an amine; and a diol.

### Silver Fine Particles

In the embodiment of the present invention, it is very important that the silver fine particles have specific particle diameters.

Specifically, the silver fine particles have an average particle diameter of 40 nm or more and 100 nm or less, the volume proportion of silver fine particles having particle diameters of 100 nm or less in the entirety of the silver fine particles is 5 % or higher and 25 % or lower, and the volume proportion of silver fine particles having particle diameters of more than 500 nm in the entirety of the silver fine particles is 10 % or higher and 60 % or lower.

In the silver fine particle composition, the average particle diameter of the silver fine particles is set to 100 nm or less, and furthermore, large particles having particle diameters of more than 500 nm are contained in a proportion of 10 % or higher on a volume basis. That is, the silver fine particle composition contains the silver fine particles having the small particle diameters and the silver fine particles having the large particle diameters in a balanced manner.

Thus, this silver fine particle composition can be fired at a low temperature, and furthermore, can be formed into a dense sintered silver layer.

From the viewpoint of decreasing the extent of volume shrinkage that occurs owing to sintering of the silver fine particles, the silver fine particles have an average particle diameter of 40 nm or more and 100 nm or less.

If the average particle diameter is less than 40 nm, a larger amount of the amine is necessary for stably dispersing the silver fine particles. Thus, the extent of volume shrinkage due to sintering increases. As a result, this increase might cause: increase in the void ratio of the sintered silver layer resulting from firing; and decrease in the bonding strength of this sintered silver layer. Meanwhile, if the average particle diameter is more than 100 nm, it becomes difficult to sinter the silver fine particles at a comparatively low temperature. In the present invention, the comparatively low temperature refers to a temperature of 200 °C or lower.

The average particle diameter is preferably 50 nm or more and 80 nm or less.

In the present invention, the average particle diameter is the primary average particle diameter of the silver fine particles and is the number-average particle diameter thereof.

The average particle diameter is obtained by observing the silver fine particles at a magnification of 50 thousand-fold by using a scanning electron beam microscope (model "S-4800" manufactured by Hitachi High-Tech Corporation), measuring particle diameters of 300 particles among the fine particles included in a taken image by using image analysis software (WinROOF created by MITANI CORPORATION), and calculating a number-average value of the particle diameters.

The silver fine particles are such that the volume proportion of silver fine particles having particle diameters of 100 nm or less in the entirety of the silver fine particles is 5 % or higher and 25 % or lower.

If the volume proportion of the silver fine particles having particle diameters of 100 nm or less is lower than 5 %, it is difficult to achieve both this volume proportion and the above average particle diameter, and the low-temperature sinterability is impaired. Meanwhile, if the volume proportion of the silver fine particles having particle diameters of 100 nm or less is higher than 25 %, excessively many fine particles come to have a small average particle diameter, whereby the extent of volume shrinkage due to firing increases. Thus, it becomes difficult to use the silver fine particle composition for bonding members having to-be-bonded surfaces that have large areas.

The volume proportion of the silver fine particles having particle diameters of 100 nm or less in the entirety of the silver fine particles is preferably 10 % or higher and 25 % or lower.

The volume proportion is calculated by using the above image analysis software.

The silver fine particles are further such that the volume proportion of silver fine particles having particle diameters of more than 500 nm in the entirety of the silver fine particles is 10 % or higher and 60 % or lower.

The silver fine particle composition containing silver fine particles having such large particle diameters enables decrease of the extent of volume shrinkage thereof at the time of firing.

If the volume proportion of the silver fine particles having particle diameters of more than 500 nm is lower than 10 %, it becomes difficult to decrease the extent of volume shrinkage at the time of firing. Meanwhile, if the volume proportion of the silver fine particles having particle diameters of more than 500 nm is higher than 60 %, it becomes difficult to achieve both this volume proportion and the above average particle diameter, and the low-temperature sinterability is impaired.

The silver fine particles are preferably such that the volume proportion of fine particles having particle diameters of more than 300 nm in the entirety of the silver fine particles is 50 % or higher and 90 % or lower.

By setting the volume proportion of the fine particles having particle diameters of more than 300 nm to 50 % or higher, volume shrinkage is less likely to occur at the time of firing.

If the volume proportion of the fine particles having particle diameters of more than 300 nm is lower than 50 %, the extent of post-firing volume shrinkage easily increases, and it becomes difficult to use the silver fine particle composition for bonding members having to-be-bonded surfaces that have large areas. Meanwhile, if the volume proportion of the fine particles having particle diameters of more than 300 nm is higher than 90 %, it becomes difficult to achieve both this volume proportion and the above average particle diameter.

The volume proportion of the fine particles having particle diameters of more than 300 nm in the entirety of the silver fine particles is more preferably 50 % or higher and 80 % or lower.

### Amine

The amine is a component for preventing aggregation of the silver fine particles and increasing the dispersion stability of the silver fine particles. The amine functions as a dispersant.

It is considered that, in the silver fine particle composition, the amine is present so as to at least partially coordinate with the silver fine particles, thereby performing protection such that the silver fine particles do not aggregate. Thus, an amine having a polar group is used as the amine.

An amine having 4 to 8 carbon atoms is preferable as the amine having such a function.

From the viewpoint of ensuring the low-temperature sinterability of the silver fine particle composition, a primary amine having a boiling point of 180 °C or lower is preferable as the amine.

If the amine remains at the time of fusion of the silver fine particle composition, fusion between the silver fine particles is hindered. Thus, the amine is desirably evaporated or decomposed so as to be separated from the surfaces of the silver fine particles early at the time of firing. From this viewpoint, the boiling point of the amine is preferably 180 °C or lower and more preferably 150 °C or lower.

In the present invention, the boiling point refers to a boiling point at 1 atm.

Selection of a primary amine as the amine is advantageous in that this selection leads to a smaller extent of steric hindrance so that the primary amine is more easily attracted to the silver fine particles and the effect of stabilizing dispersion of the silver fine particles becomes higher, than in a case where a secondary amine or a tertiary amine is selected.

The amine may be a straight chain or may have a branched chain.

The amine may be a compound containing a functional group other than an amine, such as a hydroxyl group, a carboxyl group, an alkoxy group, a carbonyl group, an ester group, or a mercapto group, for example.

Preferable specific examples of the amine include 3-methoxypropylamine, 3-ethoxypropylamine, 3-propoxypropylamine, 3-butoxypropylamine, 2-ethoxypropylamine, 3-isopropoxypropylamine, 2-methoxy-2-methylpropylamine, hexylamine, heptylamine, octylamine, 2-(2-aminoethoxy)ethanol, etc. These types of amines may be used singly, or two or more of these types of amines may be used in combination.

The content of the amine in the silver fine particle composition is preferably 0.1 wt% or higher and 5 wt% or lower.

If the content of the amine in the silver fine particle composition is 0.1 wt% or higher, the effect of a dispersant is exhibited, and the silver fine particle composition tends to have favorable dispersion stability. Meanwhile, if the content of the amine is 5 wt% or lower, the amount of the amine that hinders fusion between the silver fine particles easily becomes zero or minute at the time of firing.

The content of the amine more preferably has a lower limit and an upper limit of 0.2 wt% and 4 wt%, respectively, and further preferably has a lower limit and an upper limit of 0.3 wt% and 3 wt%, respectively.

### Diol

The diol functions as a dispersion medium in the silver fine particle composition.

In a case where the diol is used as a dispersion medium, the viscosity of the silver fine particle composition is easily adjusted. In addition, in a case where the diol is used as a dispersion medium, lifespan at the time of using the silver fine particle composition as an application paste is easily ensured.

From the viewpoint of ease of handling at the time of applying the silver fine particle composition as a bonding material onto a to-be-bonded member, a diol having a boiling point of 200 °C or higher is preferable as the diol.

A diol having 5 to 9 carbon atoms is preferable as the diol which functions as a dispersion medium.

Preferable specific examples of the diol include 1,2-octanediol, 2-methyl-2,4-pentanediol, 2-ethyl-1,3-hexanediol, 2,4-diethyl-1,5-pentanediol, 3-methyl-1,3-butanediol, etc.

These types of diols may be used singly, or two or more of these types of diols may be used in combination.

The silver fine particle composition may further contain, as a component that functions as a dispersion medium, an alcohol (an alcohol having one hydroxy group or having three or more hydroxy groups) other than diols.

The silver fine particle composition may contain, as a component that functions as a dispersion medium, a compound such as isotridecanol or 2,2,4-trimethyl-1,3-pentanediol monoisobutyrate (also called Texanol). If these components are contained, the viscosity of the silver fine particle composition is more easily adjusted.

The concentration of the diol in the entirety of the silver fine particle composition is preferably 2 wt% or higher and 15 wt% or lower.

If the concentration of the diol is within this range, separation between the diol and the silver fine particles can be effectively prevented, whereby the application stability of the silver fine particle composition is improved.

On the other hand, if the concentration of the diol is lower than 2 wt%, the silver fine particle composition comes to have an excessively high shear viscosity, and thus comes to have poor handleability and becomes difficult to be applied onto a to-be-bonded member. Meanwhile, if the concentration of the diol is higher than 15 wt%, the proportion of the fluid contained in the silver fine particle composition increases, and the precipitation speed of the silver fine particles increases.

Consequently, separation between the diol and the silver fine particles in the silver fine particle composition is not effectively prevented, whereby the stability of the silver fine particle composition might decrease. Furthermore, the content of the silver fine particles in the silver fine particle composition decreases, whereby the density of the silver sintered body obtained through firing might decrease, and a sufficient strength thereof might not be obtained.

The concentration of the diol is more preferably 3 wt% or higher and 12 wt% or lower.

In the silver fine particle composition, the total amount of components other than the silver fine particles is preferably small in such a range that performances of the silver fine particle composition are not impaired.

The content of the silver fine particles in the entirety of the silver fine particle composition is preferably 85 wt% or higher and 97 wt% or lower.

If the content of the silver fine particles is lower than 85 wt%, there is a concern that the volume significantly decreases when a firing step is performed. In addition, a larger amount of gas is generated at the time of firing, whereby voids are easily generated in the silver sintered body. Meanwhile, if the content of the silver fine particles is higher than 97 wt%, the silver fine particle composition might be unable to maintain the form of a paste, and the silver fine particles might aggregate, whereby the viscosity of the silver fine particle composition might be changed. In this case, the silver fine particle composition might be unable to be stably applied.

The silver fine particle composition may contain a polymer dispersant. The polymer dispersant can further improve the dispersibility of the silver fine particles and can function as a dispersion medium for the silver fine particles.

As the polymer dispersant, a commercially available product may be used.

Examples of the commercially available product may include: SOLSPERSE 11200, SOLSPERSE 13940, SOLSPERSE 16000, SOLSPERSE 17000, SOLSPERSE 18000, SOLSPERSE 20000, SOLSPERSE 21000, SOLSPERSE 24000, SOLSPERSE 26000, SOLSPERSE 27000, and SOLSPERSE 28000 (manufactured by Lubrizol Japan Ltd.); DISPERBYK 118, DISPERBYK 142, DISPERBYK 160, DISPERBYK 161, DISPERBYK 162, DISPERBYK 163, DISPERBYK 166, DISPERBYK 170, DISPERBYK 180, DISPERBYK 182, DISPERBYK 184, DISPERBYK 190, and DISPERBYK 2155 (manufactured by BYK Japan KK); EFKA-46, EFKA-47, EFKA-48, and EFKA-49 (manufactured by EFKA Chemicals Co.); polymer 100, polymer 120, polymer 150, polymer 400, polymer 401, polymer 402, polymer 403, polymer 450, polymer 451, polymer 452, and polymer 453 (manufactured by EFKA Chemicals Co.); AJISPER PB711, AJISPER PA111, AJISPER PB811, and AJISPER PW911 (manufactured by AJINOMOTO CO., INC.); FLOWLEN DOPA-15B, FLOWLEN DOPA-22, FLOWLEN DOPA-17, FLOWLEN TG-730W, FLOWLEN G-700, and FLOWLEN TG-720W (manufactured by KYOEISHA CHEMICAL Co., LTD.); etc.

In a case where the silver fine particle composition contains any of these polymer dispersants, the content of the polymer dispersant is preferably 1 wt% or lower. If the content of the polymer dispersant is higher than 1 wt%, fusion between the silver fine particles is easily hindered at the time of firing.

In the silver fine particle composition of the present embodiment, for example, an optional component such as an oligomer component which functions as a binder, a resin component, an organic solvent (in which a solid component may be partially dissolved or dispersed), a surfactant, a thickener, or a surface tension modifier may be added in addition to the above components in order to impart a moderate viscosity according to the purpose of usage and impart properties such as close-contact properties, drying properties, or printability unless the advantageous effects of the present invention are impaired. The optional component is not particularly limited.

Examples of the resin component include polyester-based resins, polyurethane-based resins, polyacrylate-based resins, polyacrylamide-based resins, polyether-based resins, melamine-based resins, terpene-based resins, etc. These types of resin components may be used singly, or two or more of these types of resin components may be used in combination.

Examples of the organic solvent include methyl alcohol, ethyl alcohol, n-propyl alcohol, 2-propyl alcohol, 1,2,6-hexanetriol, 1-ethoxy-2-propanol, 2-butoxyethanol, ethylene glycol, diethylene glycol, triethylene glycol, polyethylene glycols having weight-average molecular weights within a range of 200 or more and 1,000 or less, propylene glycol, dipropylene glycol, tripropylene glycol, polypropylene glycols having weight-average molecular weights within a range of 300 or more and 1,000 or less, N,N-dimethylformamide, dimethyl sulfoxide, N-methyl-2-pyrrolidone, N,N-dimethylacetamide, glycerin, acetone, etc. These types of organic solvents may be used singly, or two or more of these types of organic solvents may be used in combination.

In a case where any of these organic solvents is contained, the organic solvent sometimes functions as a dispersion medium for the silver fine particles.

Examples of the thickener include: emulsions such as polyester-based emulsion resins, acrylic-based emulsion resins, polyurethane-based emulsion resins, and blocked isocyanates; cellulose derivatives such as methylcellulose, carboxymethylcellulose, hydroxyethylcellulose, hydroxypropylcellulose, and hydroxypropyl methylcellulose; polysaccharides such as xanthan gum and guar gum; etc. These types of thickeners may be used singly, or two or more of these types of thickeners may be used in combination.

The surfactant is not particularly limited, and any of an anionic surfactant, a cationic surfactant, and a nonionic surfactant may be used. Examples of the surfactant include alkylbenzenesulfonate, quaternary ammonium salts, etc. A fluorine-based surfactant is preferable since a relevant effect is obtained by adding a small amount of the fluorine-based surfactant.

The silver fine particle composition preferably has a shear viscosity of 100 Pa s or higher, the shear viscosity being measured at a shear rate of 5 s⁻¹.

If the shear viscosity is 100 Pa s or higher, the silver fine particle composition does not flow downward when the silver fine particle composition is applied onto a to-be-bonded member. Thus, the application thickness of the silver fine particle composition can be set to a desired thickness.

In addition, to-be-bonded members that have been bonded with this silver fine particle composition can endure a high-strain test such as a temperature cycle test.

Meanwhile, if the shear viscosity is lower than 100 Pa s, it becomes difficult to thickly apply the silver fine particle composition, and it becomes difficult to form a bonding layer that can endure a high strain.

However, if the shear viscosity of the silver fine particle composition is excessively high, the application method therefor might be limited or the spreadability thereof on a to-be-bonded member might become poor, resulting in inconvenience in handling.

From these viewpoints, the shear viscosity is preferably 100 Pa s or higher and 500 Pa s or lower. The shear viscosity is more preferably 100 Pa s or higher and 400 Pa s or lower.

The shear viscosity is measured by using a cone-plate viscometer (rheometer "Physica MCR301" manufactured by Anton Paar GmbH).

Here, pre-shear is applied first at 10 s⁻¹ with a cone and a plate (diameter: 25 mm, angle: 2°, gap: 0.105 mm) under a condition of 25 °C, and then the shear rate is changed in a range from 0.1 to 100 s⁻¹. Variation in the viscosity at the time of this change is measured to obtain 27 values. Thus, the value at 5 s⁻¹ is read.

The shear viscosity can be adjusted by, for example, adjusting the particle diameters of the silver fine particles, adjusting the content of the amine, adjusting the amount of the diol or another component to be added, adjusting the blending ratio among the components, or adding the thickener.

### Manufacturing Method for Silver Fine Particle Composition

Examples of the method for manufacturing the above silver fine particles include a method that includes preparing silver fine particles having surfaces to which an amine has been bound and subsequently kneading the obtained silver fine particles with a diol so as to disperse the silver fine particles in the diol.

The method for preparing silver fine particles having surfaces to which an amine has been bound is not particularly limited, and examples of this method include a method that includes preparing a liquid dispersion containing silver fine particles and subsequently cleaning the liquid dispersion, etc.

The step of preparing a liquid dispersion containing silver fine particles only has to include, for example, reducing a silver salt (or silver ions) dissolved in a solvent, as described below. As a procedure for the reduction, a procedure based on a chemical reduction method may be employed. Alternatively, a metal amine complex decomposition method may be employed.

Specifically, the liquid dispersion can be prepared by, for example, performing reduction on a raw material liquid containing: a silver salt for forming silver fine particles; an amine having 4 to 8 carbon atoms; the above polymer dispersant blended as necessary; and a dispersion solvent (organic solvent). In the raw material liquid, some of the components may be dispersed without being dissolved. The raw material liquid may contain water.

Through this reduction, silver fine particles having surfaces to parts of which the amine has been bound is obtained.

As a starting material for obtaining the silver fine particles having surfaces to parts of which the amine has been bound, any of various publicly-known silver salts or a hydrate thereof may be used. Examples of the starting material may include silver salts such as silver nitrate, silver sulfate, silver chloride, silver oxide, silver acetate, silver oxalate, silver formate, silver nitrite, silver chlorate, and silver sulfide. The starting material is not particularly limited as long as the starting material can be dissolved in an appropriate dispersion medium and can be reduced. These types of starting materials may be used singly, or two or more of these types of starting materials may be used in combination.

The method for reducing any of these silver salts in the raw material liquid is not particularly limited, and examples of this method include: a method in which a reductant is used; a method that includes radiating light such as ultraviolet rays, electron beams, ultrasonic waves, or thermal energy; etc. Among these methods, the method in which a reductant is used is preferable from the viewpoint of easy operation.

Examples of the reductant include: amine compounds such as dimethylaminoethanol, methyldiethanolamine, triethanolamine, phenidone, and hydrazine; hydrogen compounds such as sodium borohydride, hydrogen iodide, and hydrogen gas; oxides such as carbon monoxide and sulfurous acid; low-valence metal salts such as ferrous sulfate, iron oxide, iron fumarate, iron lactate, iron oxalate, iron sulfide, tin acetate, tin chloride, tin diphosphate, tin oxalate, tin oxide, and tin sulfate; and other reductants such as ethylene glycol, glycerin, formaldehyde, hydroquinone, pyrogallol, tannin, tannic acid, salicylic acid, and sugars such as D-glucose. The reductant is not particularly limited as long as the reductant is dissolved in a dispersion medium and can reduce the above silver salt. In a case where the reductant is used, the reduction reaction may be promoted by applying light and/or heat.

By using the above silver salt, the above amine, a dispersion solvent, and the above reductant, silver fine particles having surfaces to which the amine has been bound are prepared, and examples of a specific method for the preparation include a method that includes dissolving the above silver salt in an organic solvent (e.g., toluene or the like) so as to prepare a silver salt solution, adding the above amine to this silver salt solution, and subsequently gradually dripping, into the mixture, a solution in which the above reductant has been dissolved, etc.

In the resultant liquid dispersion (obtained as described above) containing the silver fine particles having surfaces to which the amine has been bound, counterions of the silver salt, a residue of the reductant, and molecules of the amine that are not bound to the silver fine particles are present in addition to the silver fine particles. Consequently, the concentration of electrolytes and the concentration of organic matter in the entire liquid tend to be high. The liquid in such a state has a high electric conductivity, and thus the silver fine particles easily flocculate so as to precipitate. Considering this, the solution containing the silver fine particles is preferably cleaned such that the unnecessary residues are removed.

Examples of a method for this cleaning include: a method of repeating a process several times, the process including leaving the liquid dispersion, which contains the silver fine particles having surfaces to which the amine has been bound, at rest for a certain time so as to generate a supernatant liquid, removing the supernatant liquid, subsequently adding an alcohol (methanol or the like), agitating the mixture again, further leaving the liquid dispersion at rest for the certain time so as to generate a supernatant liquid, and removing the supernatant liquid; a method that includes performing centrifugal separation, instead of leaving the liquid dispersion at rest as described above; a method that includes desalting the liquid dispersion by using an ultrafiltration device, an ion exchanger, or the like; etc.

Through such cleaning, the unnecessary residues are removed, and the organic solvent is also removed, whereby it is possible to obtain silver fine particles having surfaces to which the amine has been bound, the silver fine particles being suitable for the above silver fine particle composition.

Silver fine particles having surfaces to which an amine has been bound can also be manufactured by employing the metal amine complex decomposition method.

In a case where the above metal amine complex decomposition method is employed, such silver fine particles may be manufactured through, for example, a first step of mixing an amine having a polar group and a silver compound containing a silver atom so as to generate a complex compound containing the silver compound and the amine and a second step of heating the complex compound so as to cause decomposition thereof, thereby generating such silver fine particles.

For example, a complex compound formed from an amine and a silver-containing metal compound such as silver oxalate is heated in the presence of the amine such that a metal compound of oxalate ions and the like contained in the complex compound is decomposed so as to generate atomic silver, and the atomic silver is aggregated, whereby silver fine particles having surfaces to which the amine has been bound can be manufactured.

In a case where the silver fine particles are manufactured through the above metal amine complex decomposition method, a large number of molecules of the amine have generated coordinate bonds, which have comparatively weak forces, with respect to the surfaces of the manufactured silver fine particles. These molecules of the amine form dense protective coating films on the surfaces of the silver fine particles, whereby silver fine particles having excellent preservation stability and having clean surfaces can be manufactured.

In addition, the molecules of the amine forming the coating films can be easily separated through heating or the like. Thus, the obtained silver fine particles are silver fine particles that can be sintered at a very low temperature.

The above silver fine particle composition can be obtained by kneading a diol and the silver fine particles (obtained through the above method) having surfaces to which the amine has been bound.

The method for kneading the diol and the silver fine particles to which the amine has been bound is not particularly limited, and the kneading may be performed through a conventional publicly-known method by using an agitator, a stirrer, or the like. Alternatively, agitation may be performed by using a tool such as a spatula, and an ultrasonic homogenizer with an appropriate output may be applied.

The silver fine particle composition according to the embodiment of the present invention has a predetermined particle diameter distribution.

The particle diameter distribution of the above silver fine particles can be adjusted by, for example, changing the blending ratio among the raw materials.

In a case where the silver fine particles are manufactured through the metal amine complex decomposition method, the particle diameter distribution of the silver fine particles can be adjusted according to, for example, a heating condition in the above second step. In order to attain the predetermined particle diameter distribution of the silver fine particles, a method that includes adjusting the temperature increase rate in the above second step within a range of 3 °C/min or higher and 20 °C/min or lower may be employed, for example.

If the temperature increase rate is higher than 20 °C/min, the particle size distribution of the silver fine particles tends to be narrowed. Meanwhile, if the temperature increase rate is lower than 3 °C/min, the average particle diameter of the silver fine particles tends to be increased.

Heating means in this step is not particularly limited, and examples of the heating means include thermostats, oil baths, various types of heaters, microwaves, hot plates, etc. In order to realize a complicated particle diameter distribution of the silver fine particles, heating means that can control the heating condition while actually measuring the temperature of the reaction liquid is preferable. Meanwhile, in order to stably produce the silver fine particles, heating means that allows a temperature program to be set is preferable.

Alternatively, the silver fine particles having the predetermined particle diameter distribution can also be manufactured by: preparing different kinds of silver fine particles obtained under respective different conditions through change of the blending ratio among the raw materials or the heating condition in the second step of the metal amine complex decomposition method; and mixing these kinds of silver fine particles.

### Method for Using Silver Fine Particle Composition

The above silver fine particle composition can be used as a bonding composition.

For example, in a case where two to-be-bonded members (a first to-be-bonded member and a second to-be-bonded member) are bonded, the first to-be-bonded member and the second to-be-bonded member can be bonded through:
(1) an application step of applying the bonding composition (silver fine particle composition) between the first to-be-bonded member and the second to-be-bonded member; and
(2) a firing step of firing, at a desired temperature (e.g., 200 °C or lower, preferably about 150 °C), the bonding composition applied between the first to-be-bonded member and the second to-be-bonded member.

In the firing step, pressure may be applied in a direction in which the first to-be-bonded member and the second to-be-bonded member face each other. However, a sufficient bonding strength can be obtained without necessarily having to apply pressure. This is also one of the advantages of the silver fine particle composition according to the embodiment of the present invention. Also, the temperature may be increased and decreased stepwise at the time of firing. Also, a surfactant, a surface activator, or the like may be applied to surfaces of the to-be-bonded members in advance.

The term "applying" in the application step is a concept encompassing a case of planarly applying the bonding composition and a case of linearly applying (drawing) the bonding composition. The shape of a coating film formed from the applied bonding composition having yet to be fired through heating can be set to a desired shape.

Therefore, the bonding layer formed through the firing step includes a planar bonding layer or a linear bonding layer.

The first to-be-bonded member and the second to-be-bonded member that can be bonded by using the bonding composition are not particularly limited as long as the to-be-bonded members can be bonded by applying the bonding composition therebetween and firing the bonding composition through heating. The to-be-bonded members are preferably members each having such a heat resistance as not to be damaged owing to the temperature at the time of the bonding.

Examples of materials for forming such to-be-bonded members may include polyesters such as polyamide (PA), polyimide (PI), polyamide-imide (PAI), polyethylene terephthalate (PET), polybutylene terephthalate (PBT), and polyethylene naphthalate (PEN), polycarbonate (PC), polyethersulfone (PES), vinyl resins, fluorine resins, liquid crystal polymers, ceramic, glass, metals, etc.

The shape of each of the to-be-bonded members is not particularly limited, and examples of the shape include various shapes such as the shapes of plates and strips. In addition, the to-be-bonded member may be rigid or flexible. Furthermore, a dimension of the to-be-bonded member may be selected as appropriate.

The to-be-bonded member may have a surface layer such as a primer layer formed thereon or may be subjected to surface treatment such as corona treatment, plasma treatment, UV treatment, or electron beam treatment for the purpose of, for example, improving adhesiveness or close-contact properties with respect to the bonding composition.

Examples of the first to-be-bonded member and the second to-be-bonded member include resin substrates, metal plates, light-emitting elements such as LEDs, semiconductor chips, ceramic substrates on which electronic circuits are formed, etc. The bonding layer (sintered layer) formed by using the bonding composition has high bonding strength, and thus can also be suitably used for bonding between: a light-emitting element such as an LED, a semiconductor chip, or the like; and a metal substrate, a ceramic substrate, or the like.

For the step of applying the bonding composition onto the first to-be-bonded member and/or the second to-be-bonded member, it is possible to employ various methods, e.g., dipping, screen printing, a spray process, a bar coating process, a spin coating process, an inkjet process, a dispenser process, a pin transfer method, a stamping method, an application process with a brush, a casting process, a flexo process, a gravure process, an offset method, a transfer method, a hydrophilic-and-hydrophobic-pattern method, a syringe process, pin transfer, stencil printing, or the like. The bonding composition has a high solid concentration, and thus can be suitably used in a dispenser process, pin transfer, or stencil printing among these methods.

The method for performing the above firing is not particularly limited and only has to be performed by using, for example, a conventional publicly-known oven or the like and performing heating at a temperature at which the temperature of the bonding composition applied or drawn onto the to-be-bonded member(s) becomes, for example, 200 °C or lower.

The lower limit of the temperature in this heating is not necessarily limited and is preferably a temperature at which the to-be-bonded members can be bonded to each other and which is in such a range that the advantageous effects of the present invention are not impaired.

In the sintered layer formed through the firing step, the amount of remaining organic matter derived from the amine, the diol, or the like is preferably small from the viewpoint of obtaining as high a bonding strength as possible. However, the organic matter may partially remain.

The bonding composition can be, even when being fired through low-temperature heating (e.g., at 200 °C or lower), formed into a sintered layer (bonding layer) having a sufficient strength. Therefore, the bonding composition allows to-be-bonded members comparatively susceptible to heat to be bonded to each other. The time for the firing is not particularly limited and only has to be such a time that the to-be-bonded members can be bonded to each other.

### EXAMPLES

Hereinafter, the embodiment of the present invention will be more specifically described by means of Examples, but the embodiment of the present invention is not limited to the Examples below.

### Example 1

### Manufacturing of Silver Fine Particles (A)

30.0 g of silver oxalate (manufactured by TOYO CHEMICAL INDUSTRIAL Co., Ltd.) was added to a mixed solution of 35.0 g of 3-methoxypropylamine (manufactured by Tokyo Chemical Industry Co., Ltd.), 40.0 g of 3-ethoxypropylamine (manufactured by Tokyo Chemical Industry Co., Ltd.), and 33.0 g of decanol (manufactured by FUJIFILM Wako Pure Chemical Corporation) while the mixture was being agitated. Consequently, a viscous substance was obtained.

Next, the obtained viscous substance was heated to 100 °C over 12 minutes so as to be reacted.

Thereafter, 150 ml of methanol (manufactured by FUJIFILM Wako Pure Chemical Corporation) was added to the resultant reaction liquid, and the mixture was agitated. Then, silver fine particles were precipitated and separated through centrifugal separation, and the supernatant was disposed of. This operation was repeated once again, whereby silver fine particles (A) having surfaces to which the amines had been attracted were obtained.

0.3 g of 2-ethyl-1,3-hexanediol (manufactured by FUJIFILM Wako Pure Chemical Corporation) was added to 5.0 g of the silver fine particles (A), and the mixture was sufficiently kneaded. Consequently, a silver fine particle composition was obtained.

### Example 2

### Manufacturing of Silver Fine Particles (B)

Silver fine particles (B) were obtained in the same manner as in the manufacturing of the silver fine particles (A) in Example 1, except that the viscous substance was heated to 100 °C over 8 minutes.

0.3 g of the 2-ethyl-1,3-hexanediol was added to 5.0 g of the silver fine particles (B), and the mixture was sufficiently kneaded. Consequently, a silver fine particle composition was obtained.

### Example 3

### Manufacturing of Silver Fine Particles (C)

Silver fine particles (C) were obtained in the same manner as in the manufacturing of the silver fine particles (A) in Example 1, except that: the amount of the decanol was changed to 30.0 g; and the viscous substance was heated to 100 °C over 10 minutes.

0.3 g of the 2-ethyl-1,3-hexanediol was added to 5.0 g of the silver fine particles (C), and the mixture was sufficiently kneaded. Consequently, a silver fine particle composition was obtained.

### Example 4

### Manufacturing of Silver Fine Particles (D)

Silver fine particles (D) were obtained in the same manner as in the manufacturing of the silver fine particles (A) in Example 1, except that: the amount of the decanol was changed to 35.0 g; and the viscous substance was heated to 100 °C over 9 minutes.

0.3 g of the 2-ethyl-1,3-hexanediol was added to 5.0 g of the silver fine particles (D), and the mixture was sufficiently kneaded. Consequently, a silver fine particle composition was obtained.

### Example 5

A silver fine particle composition was obtained in the same manner as in Example 1, except that 0.35 g of 2,4-diethyl-1,5-pentanediol (manufactured by FUJIFILM Wako Pure Chemical Corporation) was added instead of the 2-ethyl-1,3-hexanediol.

### Example 6

### Manufacturing of Silver Fine Particles (E)

10.0 g of the silver oxalate was added to a mixed solution of 10.0 g of the 3-ethoxypropylamine and 20.0 g of 2-(2-aminoethoxy)ethanol (manufactured by FUJIFILM Wako Pure Chemical Corporation) while the mixture was being agitated. Consequently, a viscous substance was obtained.

Next, the obtained viscous substance was heated to 100 °C over 4 minutes so as to be reacted.

Thereafter, 30 ml of the methanol was added to the resultant reaction liquid, and the mixture was agitated. Then, silver fine particles were precipitated and separated through centrifugal separation, and the supernatant was disposed of. This operation was repeated once again, whereby silver fine particles (E) having surfaces to which the amines had been attracted were obtained.

### Manufacturing of Silver Fine Particles (F)

3.0 g of the silver oxalate was added to 2.0 g of the 3-methoxypropylamine while the mixture was being agitated. Consequently, a viscous substance was obtained.

Next, the obtained viscous substance was heated to 100 °C over 1.5 minutes so as to be reacted.

Thereafter, 10 ml of the methanol was added to the resultant reaction liquid, and the mixture was agitated. Then, silver fine particles were precipitated and separated through centrifugal separation, and the supernatant was disposed of. This operation was repeated once again, whereby silver fine particles (F) having surfaces to which the amine had been attracted were obtained.

0.4 g of the 2,4-diethyl-1,5-pentanediol, 0.13 g of 1,2-octanediol (manufactured by FUJIFILM Wako Pure Chemical Corporation), and 0.02 g of SOLSPERSE 21000 (manufactured by Lubrizol Corporation) were added to 3.0 g of the silver fine particles (E) and 2.0 g of the silver fine particles (F), and the mixture was sufficiently kneaded. Consequently, a silver fine particle composition was obtained.

### Example 7

### Manufacturing of Silver Fine Particles (G)

Silver fine particles (G) were obtained in the same manner as in the manufacturing of the silver fine particles (D) in Example 4, except that the amount of the decanol was changed to 40.0 g.

0.2 g of the 2-ethyl-1,3-hexanediol and 0.1 g of the 1,2-octanediol were added to 5.0 g of the silver fine particles (G), and the mixture was sufficiently kneaded. Consequently, a silver fine particle composition was obtained.

### Comparative Example 1

0.2 g of the 2-ethyl-1,3-hexanediol was added to 2.5 g of the silver fine particles (A) in Example 1 and 2.5 g of the silver fine particles (E) in Example 6, and the mixture was sufficiently kneaded. Consequently, a silver fine particle composition was obtained.

### Comparative Example 2

### Manufacturing of Silver Fine Particles (H)

30.0 g of the silver oxalate was added to a mixed solution of 9.0 g of the 3-methoxypropylamine and 90.0 g of diethylene glycol monobutyl ether acetate (manufactured by FUJIFILM Wako Pure Chemical Corporation) while the mixture was being agitated. Consequently, a viscous substance was obtained.

Next, the obtained viscous substance was heated to 140 °C over 10 minutes so as to be reacted.

Thereafter, 9.0 g of the 3-methoxypropylamine was added to the resultant reaction liquid, this reaction liquid was cooled, and 8.0 g of the 3-ethoxypropylamine was added thereto.

Furthermore, 100 ml of the methanol was added to the reaction liquid, and the mixture was agitated. Then, silver fine particles were precipitated and separated through centrifugal separation, and the supernatant was disposed of. This operation was repeated once again, whereby silver fine particles (H) having surfaces to which the amines had been attracted were obtained.

0.56 g of the 2-ethyl-1,3-hexanediol was added to 5.0 g of the silver fine particles (H), and the mixture was sufficiently kneaded. Consequently, a silver fine particle composition was obtained.

### Comparative Example 3

### Manufacturing of Silver Fine Particles (I)

30.0 g of the silver oxalate was added to a mixed solution of 4.5 g of the 3-methoxypropylamine and 90.0 g of the diethylene glycol monobutyl ether acetate while the mixture was being agitated. Consequently, a viscous substance was obtained.

Next, the obtained viscous substance was heated to 140 °C over 10 minutes so as to be reacted.

Thereafter, 9.0 g of the 3-methoxypropylamine was added to the resultant reaction liquid, and this reaction liquid was cooled.

Furthermore, 100 ml of the methanol was added to the reaction liquid, and the mixture was agitated. Then, silver fine particles were precipitated and separated through centrifugal separation, and the supernatant was disposed of. This operation was repeated once again, whereby silver fine particles (I) having surfaces to which the amine had been attracted were obtained.

0.56 g of the 2-ethyl-1,3-hexanediol was added to 5.0 g of the silver fine particles (I), and the mixture was sufficiently kneaded. Consequently, a silver fine particle composition was obtained.

### Comparative Example 4

### Manufacturing of Silver Fine Particles (J)

6.0 g of the silver oxalate was added to a mixed solution of 7.0 g of the 3-methoxypropylamine and 0.5 g of dodecylamine (manufactured by FUJIFILM Wako Pure Chemical Corporation) while the mixture was being agitated. Consequently, a viscous substance was obtained.

Next, the obtained viscous substance was heated to 100 °C over 3 minutes so as to be reacted.

Thereafter, 20 ml of the methanol was added to the resultant reaction liquid, and the mixture was agitated. Then, silver fine particles were precipitated and separated through centrifugal separation, and the supernatant was disposed of. This operation was repeated once again, whereby silver fine particles (J) having surfaces to which the amines had been attracted were obtained.

1.2 g of isotridecanol and 0.03 g of SOLSPERSE 21000 (manufactured by Lubrizol Corporation) were added to 6.0 g of the silver fine particles (J), and the mixture was sufficiently kneaded. Consequently, a silver fine particle composition was obtained.

### Comparative Example 5

### Manufacturing of Silver Fine Particles (K)

10.0 g of the silver oxalate was added to a mixed solution of 5.0 g of the 3-ethoxypropylamine and 11.0 g of the 3-methoxypropylamine while the mixture was being agitated. Consequently, a viscous substance was obtained.

Next, the obtained viscous substance was reacted by a thermostat at 120 °C.

Thereafter, 30 ml of the methanol was added to the resultant reaction liquid, and the mixture was agitated. Then, silver fine particles were precipitated and separated through centrifugal separation, and the supernatant was disposed of. This operation was repeated once again, whereby silver fine particles (K) having surfaces to which the amines had been attracted were obtained.

0.32 g of 1-decanol and 0.06 g of SOLSPERSE 16000 (manufactured by Lubrizol Corporation) were added to 4 g of the silver fine particles (K) and 4 g of the silver fine particles (E) in Example 6, and the mixture was sufficiently kneaded. Consequently, a silver fine particle composition was obtained.

### Comparative Example 6

### Manufacturing of Silver Fine Particles (L)

3.0 g of the silver oxalate was added to 3.0 g of the 3-methoxypropylamine while the mixture was being agitated. Consequently, a viscous substance was obtained.

Next, the obtained viscous substance was heated to 100 °C over 1.5 minutes so as to be reacted.

Thereafter, 10 ml of the methanol was added to the resultant reaction liquid, and the mixture was agitated. Then, silver fine particles were precipitated and separated through centrifugal separation, and the supernatant was disposed of. This operation was repeated once again, whereby silver fine particles (L) having surfaces to which the amine had been attracted were obtained.

### Manufacturing of Silver Fine Particles (M)

3.0 g of the silver oxalate was added to 6.0 g of the 2-(2-aminoethoxy)ethanol while the mixture was being agitated. Consequently, a viscous substance was obtained.

Next, the obtained viscous substance was heated to 100 °C over 15 minutes so as to be reacted.

Thereafter, 10 ml of the methanol was added to the resultant reaction liquid, and the mixture was agitated. Then, silver fine particles were precipitated and separated through centrifugal separation, and the supernatant was disposed of. This operation was repeated once again, whereby silver fine particles (M) having surfaces to which the amine had been attracted were obtained.

0.15 g of the 2,4-diethyl-1,5-pentanediol, 0.06 g of the 1,2-octanediol, and 0.01 g of SOLSPERSE 21000 (manufactured by Lubrizol Corporation) were added to 0.5 g of the silver fine particles (L) and 1.5 g of the silver fine particles (M), and the mixture was sufficiently kneaded. Consequently, a silver fine particle composition was obtained.

### Evaluation Tests

### (1) Measurement of Particle Diameter

The silver fine particles in each of the silver fine particle compositions obtained as described above were observed at a magnification of 50 thousand-fold by using a scanning electron beam microscope (model "S-4800" manufactured by Hitachi High-Tech Corporation), and, from among the fine particles included in a taken image, 300 particles were randomly extracted. The particle diameters of the 300 particles were measured with image analysis software (WinROOF created by MITANI CORPORATION), and a number-average particle diameter was calculated.

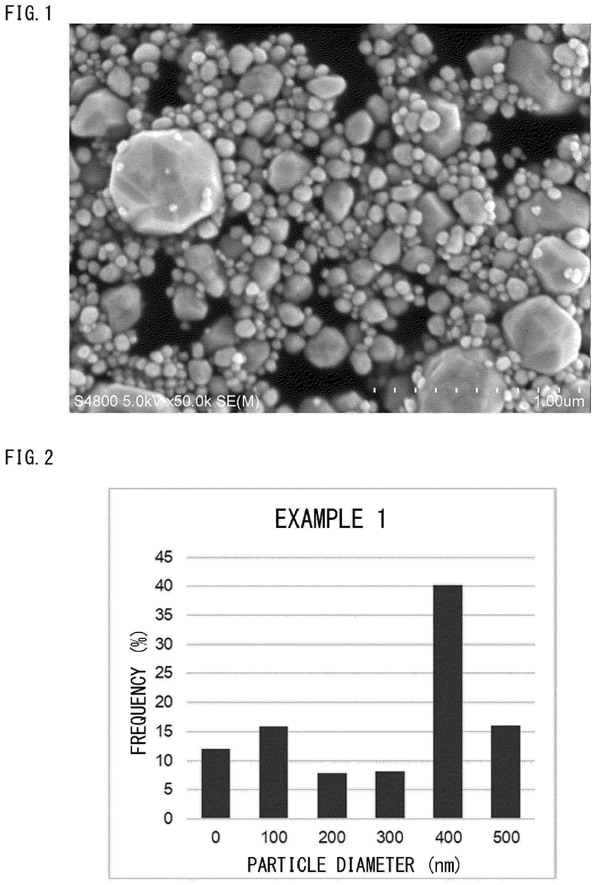

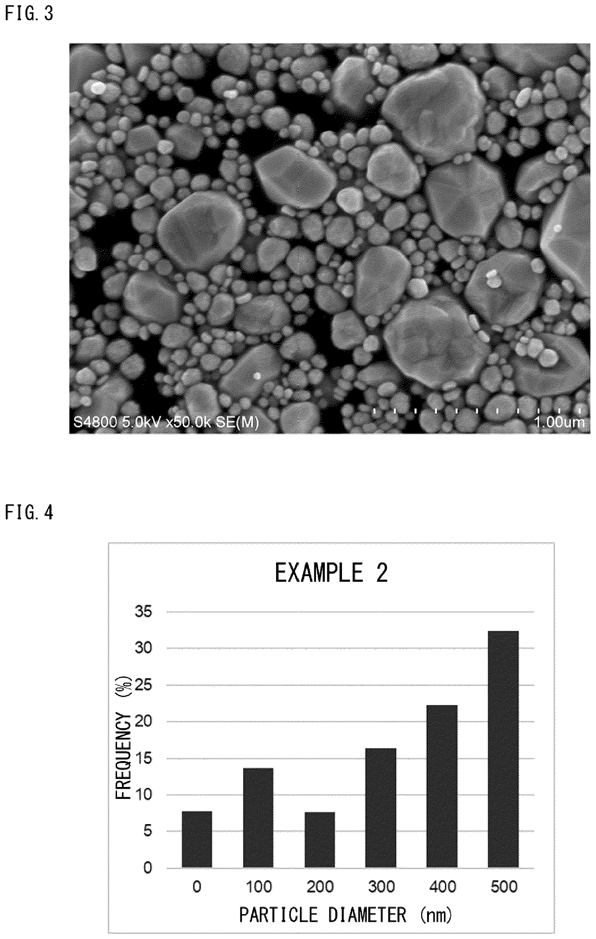

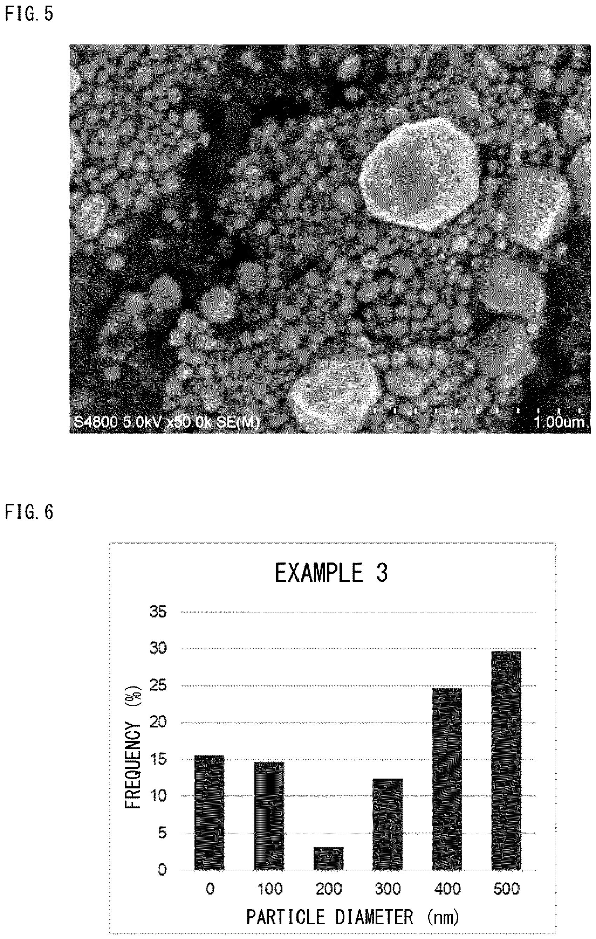

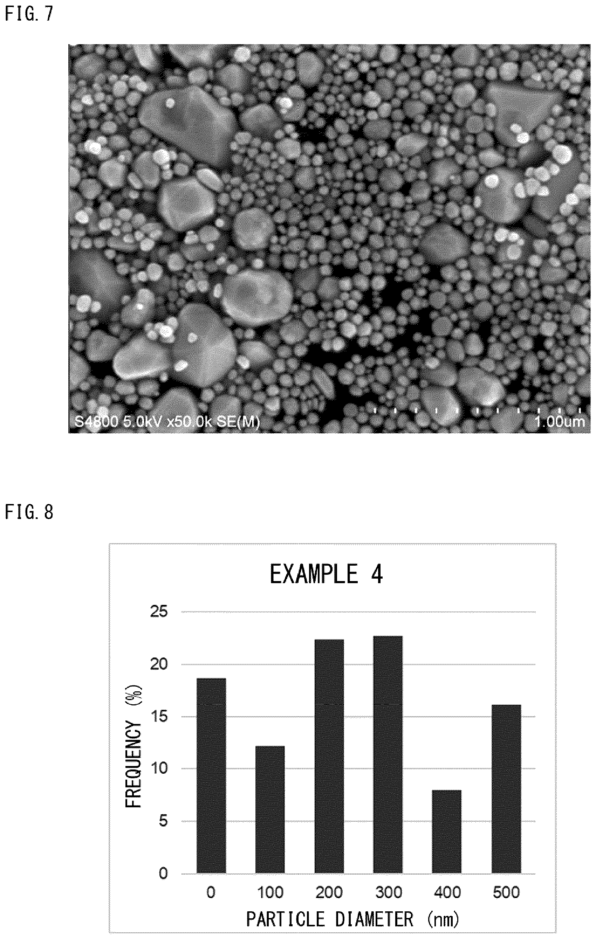

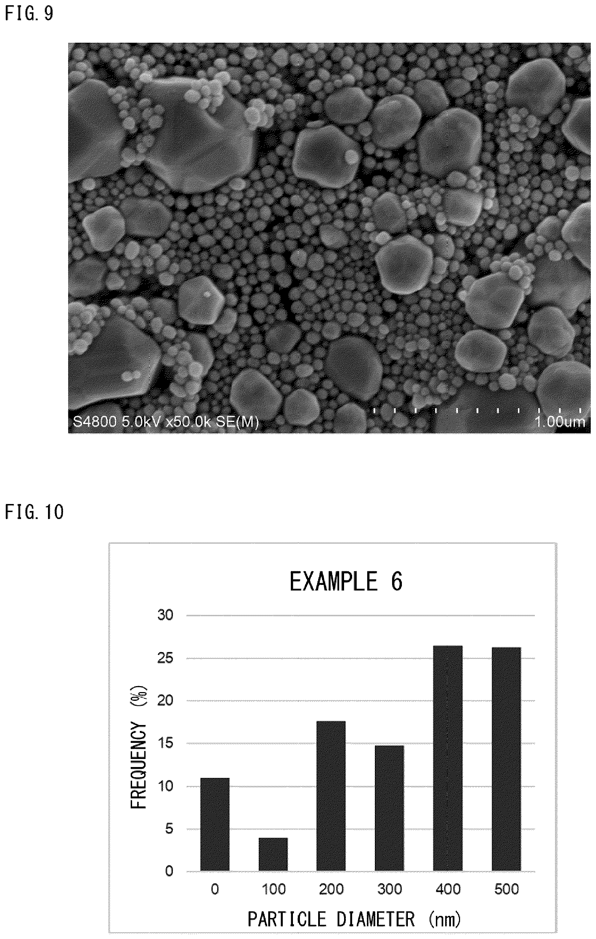

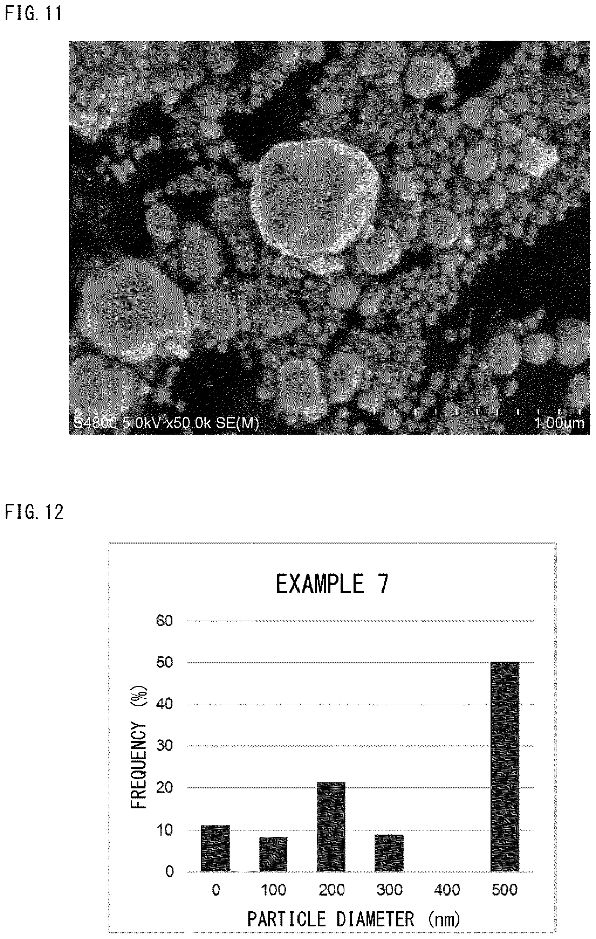

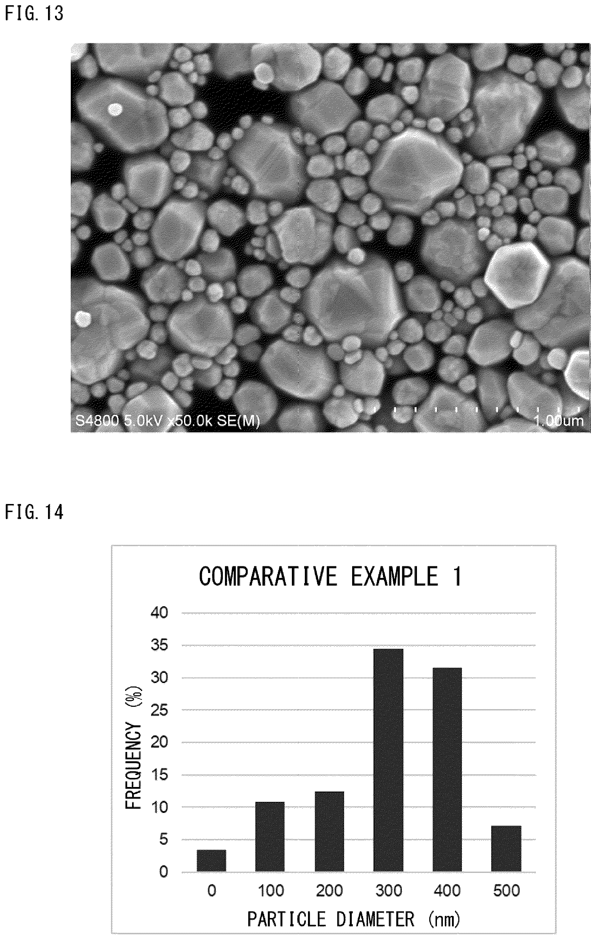

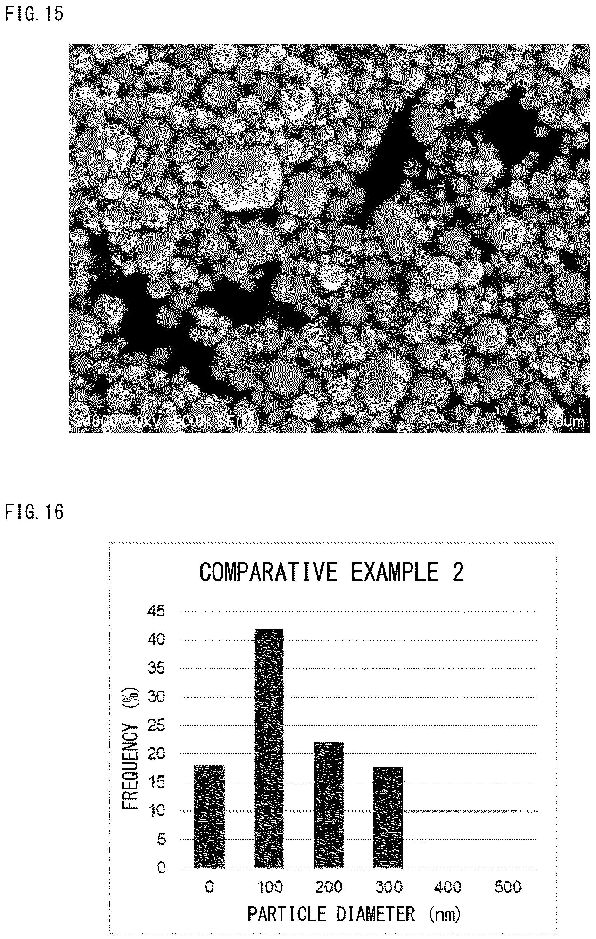

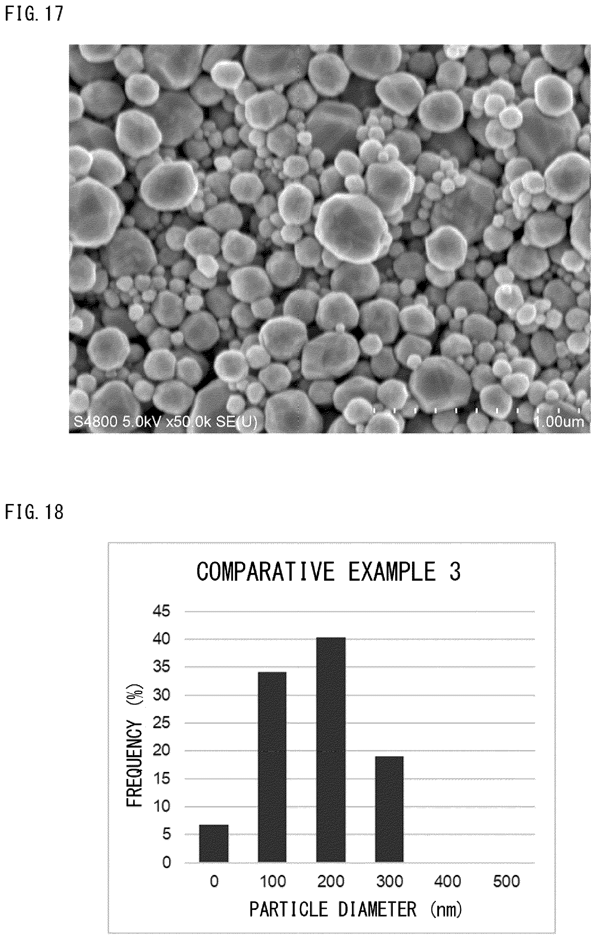

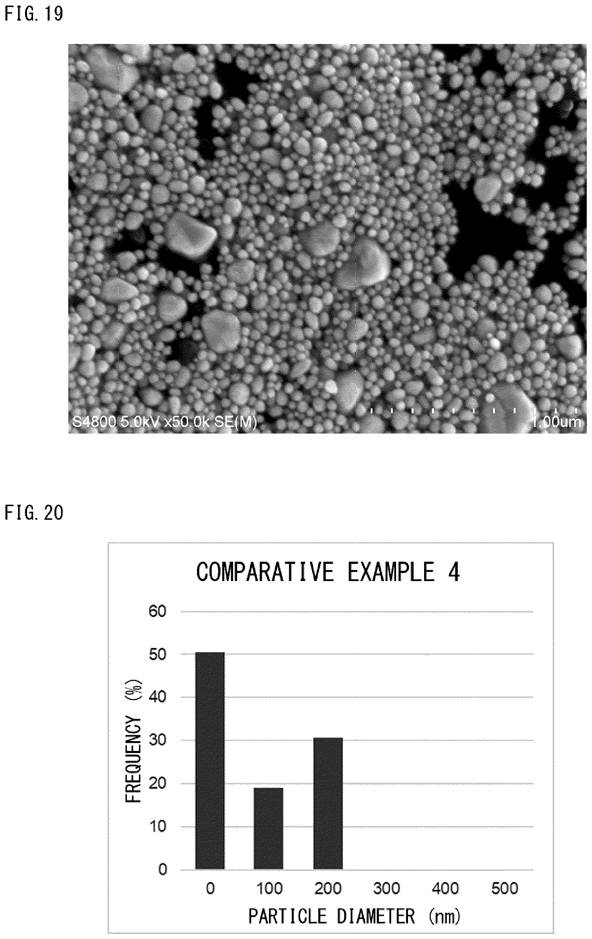

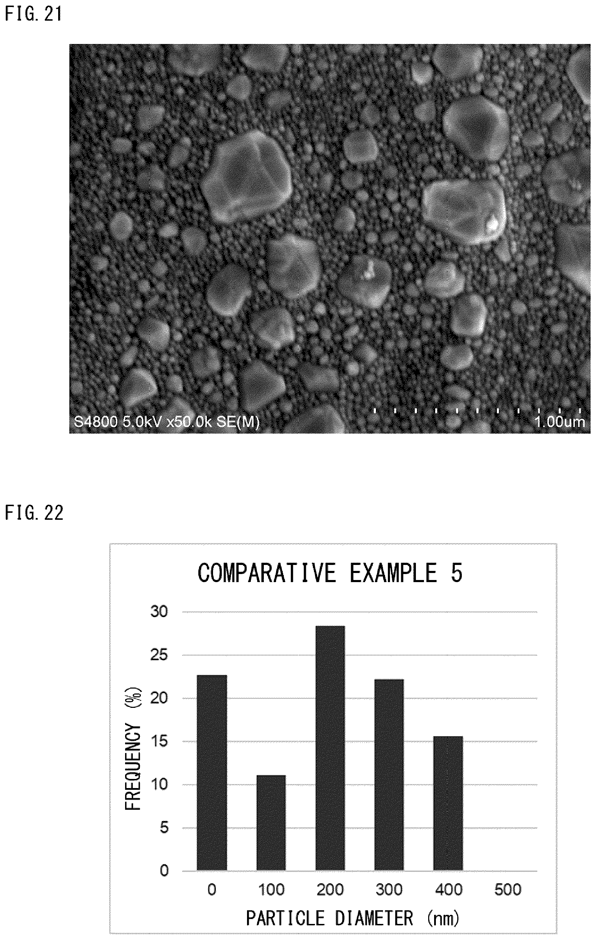

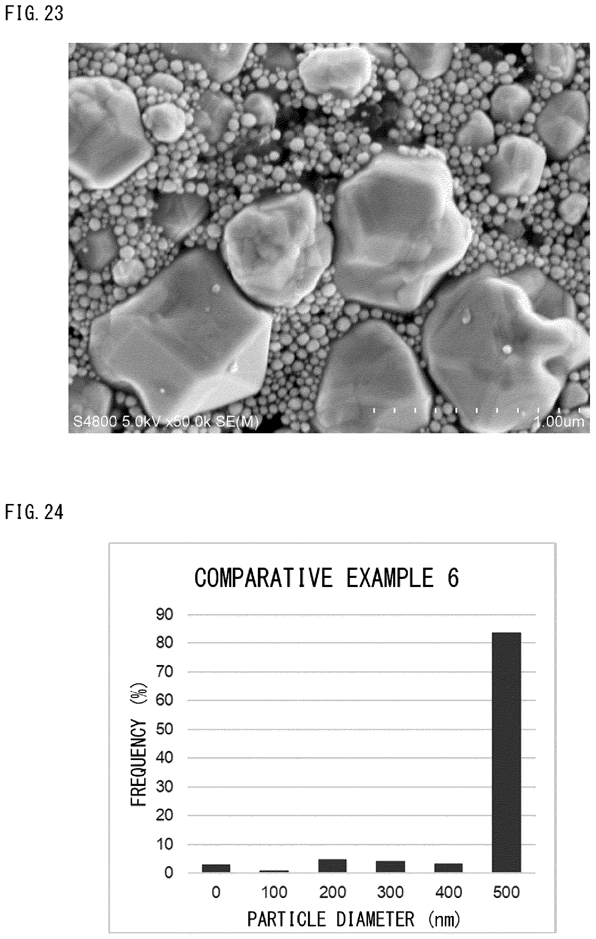

FIG. 1, FIG. 3, FIG. 5, FIG. 7, FIG. 9, FIG. 11, FIG. 13, FIG. 15, FIG. 17, FIG. 19, FIG. 21, and FIG. 23 are parts of the taken images.

Volumes of the silver fine particles were calculated based on the particle diameters of the respective particles calculated from the micrograph, on the assumption that each of the particles was a perfect sphere. Volume proportions were obtained based on the result of this calculation.

The result is shown in the corresponding one of FIG. 2, FIG. 4, FIG. 6, FIG. 8, FIG. 10, FIG. 12, FIG. 14, FIG. 16, FIG. 18, FIG. 20, FIG. 22, and FIG. 24.

Each of the drawings showing the results has a vertical axis indicating frequency (%) of volume proportion and a horizontal axis indicating particle diameter (nm). The particle diameters under the respective bar graphs in the horizontal axis have the following meanings. That is, in a case of, for example, a bar graph of 100 nm, "100 nm" means a particle diameter range of more than 100 nm and 200 nm or less, and the height of the bar graph means the total volume proportion of the particles that fall within this range. Meanwhile, "500 nm" means the total volume proportion of all the particles of more than 500 nm.

### (2) Thermal Analysis

The content of organic components (components other than the silver fine particles) contained in each of the silver fine particle compositions obtained as described above was measured through thermogravimetric analysis. Specifically, the silver fine particle composition was heated in an air atmosphere and at a temperature increase rate of 10 °C/min by using a thermogravimetry device (TG-DTA8122 manufactured by Rigaku Corporation), and the content (wt%) of the organic components was identified according to a weight decrease rate at 30 to 500 °C. The value obtained by subtracting the content (wt%) of the organic components from 100 (wt%) is indicated as the content (wt%) of the silver fine particles in the corresponding one of Tables 1 and 2.

### (3) Measurement of Void Ratio and Bonding Strength

A small amount of each of the silver fine particle compositions obtained as described above was applied through hand printing with a metal mask plate onto a copper plate (20 mm × 25 mm × 1 mm in thickness) having a surface plated with silver, and a dummy silicon carbide chip (base area: 3 mm × 3 mm, thickness: 0.2 mm, surface film structure: Au of 200 nm/Ni of 200 nm/Ti of 200 nm) was stacked onto the silver fine particle composition. At this time, in order to bring these members into close contact with each other, about 30 gf of external force was applied, but the pressure was not higher than necessary.

Thereafter, the resultant laminated body was put into an air blowing constant-temperature dryer (FV-630 manufactured by ADVANTEC CO., LTD.) and was, in an air atmosphere, fired at 70 °C for 40 minutes and then fired at 200 °C for 60 minutes. The laminated body was left until the temperature of the air blowing constant-temperature dryer decreased to 150 °C or lower. Then, the laminated body was taken out, and the void ratio (%) thereof was measured by using an ultrasonic flaw detection device (manufactured by KJTD Co., Ltd.).

Thereafter, a bonding strength test was performed by using a bond tester (manufactured by RHESCA CO., LTD.). In the bonding strength test, a load cell of 100 kgf was used. The value obtained by dividing the bonding strength at the time of peeling the dummy chip by the base area of the chip was used as a bonding strength.
The unit of the bonding strength is MPa.

The result is indicated in the corresponding one of Tables 1 and 2.

Furthermore, among the bonded samples produced through the above method, each of the bonded samples in Example 1 and Comparative Examples 2 and 4 was cut along a diagonal line of the chip, and the cross section obtained through the cutting was observed with the scanning electron beam microscope.

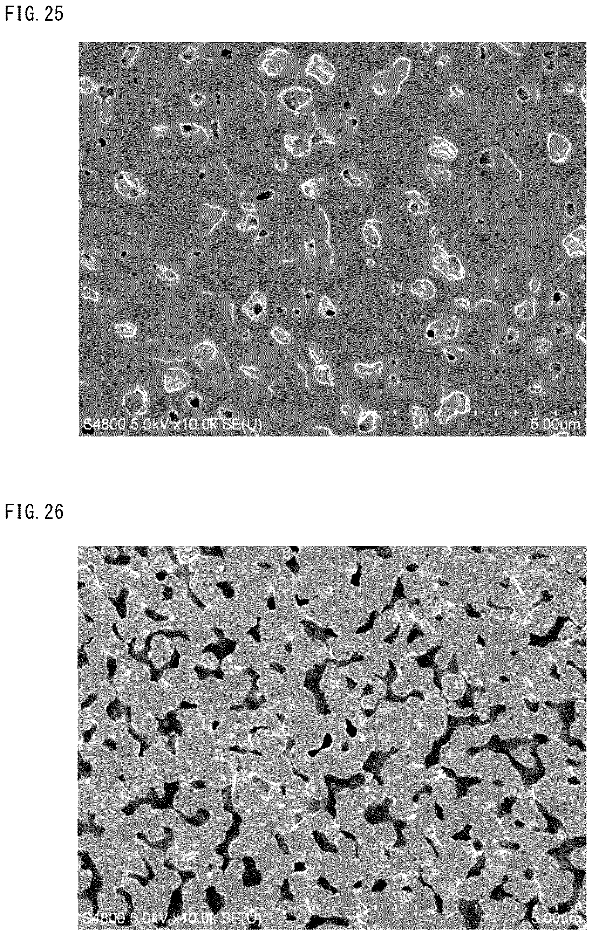

The result is shown in the corresponding one of FIG. 25, FIG. 26, and FIG. 27.

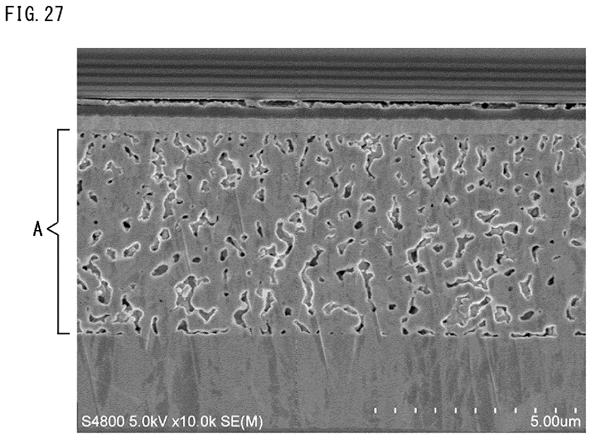

As shown in FIG. 25, FIG. 26, and FIG. 27, a large number of comparatively small voids were generated in Comparative Example 4 (FIG. 27) in which fine particles of 100 nm or less occupied the majority, and a large number of comparatively large voids were generated in Comparative Example 2 (FIG. 26) in which there were many fine particles of more than 100 nm and 200 nm or less.

Meanwhile, a situation in which a sintered silver tissue was dense was observed in Example 1 (FIG. 25), and the sintered silver tissue obtained in Example 1 firmly bonded the members to each other. This firm bonding was obvious also from the fact that: the void ratio, of the bonded sample, ascertained by the ultrasonic flaw detection device was low; and the bonded sample exhibited a high bonding strength.

In FIG. 27, the region A is the sintered silver layer, and the members above and below the sintered silver layer are respectively the chip and the copper plate.

**Table 1**

| | Example 1 | Example 2 | Example 3 | Example 4 |
|---|---|---|---|---|
| Amine component | 3 -methoxypropylamine, 3 -ethoxypropylamine | 3 -methoxypropylamine, 3 -ethoxypropylamine | 3 -methoxypropylamine, 3 -ethoxypropylamine | 3 -methoxypropylamine, 3 -ethoxypropylamine |
| Alcohol component | 2-ethyl-1,3-hexanediol | 2-ethyl-1,3-hexanediol | 2-ethyl-1,3-hexanediol | 2-ethyl-1,3-hexanediol |
| Average particle diameter (nm) | 71 | 91 | 58 | 63 |
| Volume proportion (%) of silver fine particles of 100 nm or less | 12 | 8 | 16 | 19 |
| Volume proportion (%) of silver fine particles of more than 300 nm | 64 | 71 | 67 | 47 |
| Volume proportion (%) of silver fine particles of more than 500 nm | 16 | 32 | 30 | 16 |
| Silver fine particle content (wt%) | 92.5 | 93.2 | 90.3 | 93.6 |
| Shear viscosity (Pa s at 5 s⁻¹) | 196 | 132 | 200 | 340 |
| Void ratio (%) | 0.7 | 0.9 | 1.7 | 0.9 |
| Bonding strength (MPa) | 115 | 108 | 84 | 120 |

**Table 1 (cont.)**

| | Example 5 | Example 6 | Example 7 |
|---|---|---|---|
| Amine component | 3 -methoxypropylamine, 3 -ethoxypropylamine | 3 -methoxypropylamine, 3 -ethoxypropylamine, 2-(2-aminoethoxy)ethanol | 3 -methoxypropylamine, 3 -ethoxypropylamine |
| Alcohol component | 2,4-diethyl-1,5-pentanediol | 2,4-diethyl-1,5-pentanediol, 1,2-octanediol | 2-ethyl- 1,3 -hexanediol, 1,2-octanediol |
| Average particle diameter (nm) | 71 | 55 | 63 |
| Volume proportion (%) of silver fine particles of 100 nm or less | 12 | 11 | 11 |
| Volume proportion (%) of silver fine particles of more than 300 nm | 64 | 68 | 59 |
| Volume proportion (%) of silver fine particles of more than 500 nm | 16 | 26 | 50 |
| Silver fine particle content (wt%) | 91.1 | 89.9 | 93.2 |
| Shear viscosity (Pa s at 5 s⁻¹) | 123 | 199 | 411 |
| Void ratio (%) | 2.9 | 2.2 | 0.9 |
| Bonding strength (MPa) | 104 | 77 | 92 |

**Table 2**

| | Comparative Example 1 | Comparative Example 2 | Comparative Example 3 |
|---|---|---|---|
| Amine component | 3-methoxypropylamine, 3-ethoxypropylamine, 2-(2-aminoethoxy)ethanol | 3-methoxypropylamine, 3 -ethoxypropylamine | 3-methoxypropylamine |
| Alcohol component | 2-ethyl-1,3-hexanediol | 2-ethyl-1,3-hexanediol | 2-ethyl-1,3-hexanediol |
| Average particle diameter (nm) | 125 | 76 | 106 |
| Volume proportion (%) of silver fine particles of 100 nm or less | 3 | 18 | 7 |
| Volume proportion (%) of silver fine particles of more than 300 nm | 73 | 18 | 19 |
| Volume proportion (%) of silver fine particles of more than 500 nm | 7 | 0 | 0 |
| Silver fine particle content (wt%) | 94.5 | 89.3 | 89.3 |
| Shear viscosity (Pa s at 5 s⁻¹) | 151 | 234 | 208 |
| Void ratio (%) | 14 | 11 | 61 |
| Bonding strength (MPa) | 15 | 28 | 9 |

**Table 2 (cont.)**

| | Comparative Example 4 | Comparative Example 5 | Comparative Example 6 |
|---|---|---|---|
| Amine component | 3-methoxypropylamine, dodecylamine | 3-methoxypropylamine, 3-ethoxypropylamine, 2-(2-aminoethoxy)ethanol | 3-methoxypropylamine, 2-(2-aminoethoxy)ethanol |
| Alcohol component | isotridecanol | 1-decanol | 2,4-diethyl-1,5-pentanediol, 1,2-octanediol |
| Average particle diameter (nm) | 48 | 32 | 50 |
| Volume proportion (%) of silver fine particles of 100 nm or less | 50 | 23 | 3 |
| Volume proportion (%) of silver fine particles of more than 300 nm | 0 | 38 | 91 |
| Volume proportion (%) of silver fine particles of more than 500 nm | 0 | 0 | 84 |
| Silver fine particle content (wt%) | 89.2 | 93.8 | 87.4 |
| Shear viscosity (Pa s at 5 s⁻¹) | 50 | 72 | 118 |
| Void ratio (%) | 35 | 21 | 80 |
| Bonding strength (MPa) | 56 | 59 | 30 |

### INDUSTRIAL APPLICABILITY

The silver fine particle composition according to the embodiment of the present invention can be suitably used as, for example, a bonding composition for bonding electronic materials and the like.

## Claims

1. A silver fine particle composition comprising: silver fine particles; an amine; and a diol, wherein
the silver fine particles have an average particle diameter of 40 nm or more and 100 nm or less,
a volume proportion of silver fine particles having particle diameters of 100 nm or less in an entirety of the silver fine particles is 5 % or higher and 25 % or lower, and
a volume proportion of silver fine particles having particle diameters of more than 500 nm in the entirety of the silver fine particles is 10 % or higher and 60 % or lower.

2. The silver fine particle composition according to claim 1,
wherein a volume proportion of silver fine particles having particle diameters of more than 300 nm in the entirety of the silver fine particles is 40 % or higher and 90 % or lower.

3. The silver fine particle composition according to claim 1 or 2,
wherein the amine is one or more types of amines selected from the group consisting of 3-methoxypropylamine, 3-ethoxypropylamine, 3-propoxypropylamine, 3-butoxypropylamine, 2-ethoxypropylamine, 3-isopropoxypropylamine, 2-methoxy-2-methylpropylamine, hexylamine, heptylamine, octylamine, and 2-(2-aminoethoxy)ethanol.

4. The silver fine particle composition according to any one of claims 1 to 3, wherein the diol is one or more types of diols selected from the group consisting of 1,2-octanediol, 2-methyl-2,4-pentanediol, 2-ethyl-1,3-hexanediol, 2,4-diethyl-1,5-pentanediol, and 3-methyl-1,3-butanediol.

5. The silver fine particle composition according to any one of claims 1 to 4, wherein the silver fine particles have a content of 85 wt% or higher and 97 wt% or lower.

6. The silver fine particle composition according to any one of claims 1 to 5, the silver fine particle composition having a shear viscosity of 100 Pa s or higher, the shear viscosity being measured at a shear rate of 5 s⁻¹.
